Europäisches Patentamt

(19) European Patent Office

Office européen des brevets

(11) Numéro de publication : **0 043 781**

**B1**

(12) **FASCICULE DE BREVET EUROPÉEN**

(45) Date de publication du fascicule du brevet :
12.11.86

(21) Numéro de dépôt : 81420091.1

(22) Date de dépôt : 09.06.81

(51) Int. Cl.⁴ : **C 23 C 28/04**

(54) Procédé pour la fabrication d'une couche composite résistant à la fois au grippage, à l'abrasion, à la corrosion et à la fatigue par contraintes alternées, et couche composite ainsi obtenue.

(30) Priorité : 06.06.80 FR 8013030

(43) Date de publication de la demande :
13.01.82 Bulletin 82/02

(45) Mention de la délivrance du brevet :
12.11.86 Bulletin 86/46

(84) Etats contractants désignés :
CH DE GB IT LI

(56) Documents cités :
DE-A- 2 145 254
DE-A- 2 431 448
DE-C- 970 456
FR-A- 2 170 258
FR-A- 2 279 861
FR-A- 2 412 619
US-A- 3 964 937
THIN SOLID FILMS, vol. 22, no. 83, 1974, Elsevier Sequoia S.A. LAUSANNE (CH) W.R. STOWELL: "Ion-Plated Titanium Carbide Coatings", pages 111-120
THIN SOLID FILMS, vol. 72, 15 octobre 1980, Paper presented at the International Conference on Metallurgical Coatings, San Diego, California (US), 21-25 avril 1980, Elsevier Sequoia S.A. LAUSANNE (CH) J. ARONSON et al.: "Preparation of Titanium Nitride by a pulsed D.C. magnetron reactive deposition technique using the moving mode of deposition", pages 535-540

(73) Titulaire : CENTRE STEPHANOIS DE RECHERCHES MECANIQUES HYDROMECANIQUE ET FROTTEMENT
Société dite:
Zone Industrielle Sud Rue Benoît Fourneyron
F-42160 Andrezieux Boutheon (FR)

(72) Inventeur : Gaucher, Antoine
Route de Veauche
F-42160 Andrezieux Boutheon Loire (FR)
Inventeur : Terrat, Jean-Paul
10 Rue Etienne Boisson
F-42000 Saint Etienne Loire (FR)

(74) Mandataire : Maisonnier, Jean
Bureau Maisonnier 28 rue Servient
F-69003 Lyon (FR)

## Description

La présente invention est relative à une couche composite capable de résister à la fois au grippage, à l'abrasion, à la fatigue par contraintes alternées et à la corrosion, à base d'un métal de transition tel que le titane, le tantale, le hafnium, ou autres. Elle concerne également un procédé de revêtement d'un substrat à l'aide de cette couche composite et à titre de produits industriels nouveaux, les pièces ainsi revêtues.

On notera que la pièce à revêtir peut être réalisée en matériaux très divers tels que par exemple les aciers ou les bronzes, ou les alliages d'aluminium, mais également les céramiques, le papier, la matière plastique... très souvent, cependant, la pièce est en acier et il s'agit d'une pièce mécanique. Dans la description qui va suivre, il est donc bien entendu que les mots « pièces », « substrat », peuvent désigner des matières très diverses, l'acier n'étant qu'un exemple.

On connaît diverses techniques pour déposer sur une pièce, une couche de revêtement protectrice.

Par exemple, le brevet allemand DE-A-2 431 448 concerne une couche (par exemple en nitrure ou carbure de titane) appliquée directement sur un substrat. Le mode de revêtement du substrat donne lieu à la formation de zones B, C, D, E dont le gradient de composition varie progressivement à partir d'une couche de métal pur directement au contact du substrat. Il n'est donc pas question d'une couche composite à couches unitaires distinctes.

L'article « THIN Solid Films », vol. 22, n° 84, 1974 pages 111-120 consiste également à réaliser une unique couche de revêtement par la technique de l'évaporation métallique avec variation progressive de la composition des zones de la couche.

Dans tous ces cas connus, il s'agit d'une couche unique.

On sait que les modes de vieillissement couramment appelés usure et qui peuvent affecter la surface d'une pièce mécanique, se groupent autour de quatre grands thèmes qui sont : le grippage, l'abrasion, la fatigue par contraintes alternées, la corrosion.

Le grippage se produit notamment lorsque le matériau de la surface d'un corps frottant peut former des composés intermétalliques, par exemple, par diffusion, avec le matériau qui constitue la surface du corps antagoniste.

L'abrasion est particulièrement intense lorsque la surface tendre d'une pièce est rayée ou arrachée par les aspérités du corps antagoniste plus dur, ou par des particules dures présentes dans l'ambiance.

La fatigue par contraintes alternées peut amener soit des déchirures superficielles perpendiculaires à la direction du frottement, soit des cisaillements profonds qui isolent peu à peu la couche superficielle et favorisent alors son égrènement.

Quant à la corrosion, elle est particulièrement néfaste lorsqu'elle peut se développer vers l'intérieur du matériau, en suivant des chemins de moindre résistance.

C'est une des quêtes fondamentales de la mécanique de chercher à retarder le vieillissement des pièces par l'un ou l'autre de ces modes principaux et surtout de trouver des palliatifs valables pour ces quatre modes de vieillissement pris ensemble.

La présente invention a pour but de réaliser un revêtement aux résultats particulièrement spectaculaires dans son action contre un, plusieurs, ou les quatre modes principaux de vieillissement précités.

La présente invention repose sur les observations suivantes :

1. Une couche frottante résiste d'autant mieux au vieillissement par fatigue qu'elle permet mieux l'accomodement. En effet, ce vieillissement est formé par l'accumulation de micro-atteintes ponctuelles du domaine plastique, lorsque se superposent localement un état de contraintes excessif et une zone de moindre résistance provenant d'une hétérogénéité de la structure. La présence de zones de haute ductilité, fluant facilement, permet alors d'écrêter les contraintes excessives et donc de diminuer le vieillissement.

2. La forme la plus néfaste de corrosion c'est-à-dire celle qui mène à des vieillissements rapides et dangereux, n'est pas le genre de phénomène qui affecte une pièce par toute sa surface, comme par exemple le noircissement des pièces en argent ou le ternissement de l'étain, mais au contraire celle qui, ayant trouvé un tracé de moindre résistance, chemine vers l'intérieur du corps. Ce sera le cas, par exemple de certains joints de grains, ou des alignements de macrostructures basaltiques. De tels cheminements peuvent être arrêtés si le chemin préférentiel s'interrompt en butant sur une autre structure plus profonde, dont les points faibles ne coïncident pas avec ceux de la macrostructure superficielle.

3. Une surface résiste d'autant mieux à l'abrasion qu'elle est très dure.

4. On évite généralement la formation de composés intermétalliques en revêtant la surface extérieure d'un composé métal/non-métal, tel que nitrure, carbure, oxyde, siliciure...

On peut donc conclure, de ces observations, qu'une surface résistera particulièrement bien au vieillissement si l'on sait établir des anisotropies judicieuses de façon à réaliser à la fois les accomodements qui empêcheront ou au moins retarderont le vieillissement par contraintes, et les barrages qui empêcheront les corrosions fissurantes de cheminer.

C'est ce que réalise la couche composite conforme à l'invention et, lorsque les pièces sont revêtues d'une telle couche, on constate une augmentation sensible et surprenante de leur résistance aux quatre modes de vieillissement précités, pris ensemble ou séparément, ainsi que le feront apparaître les exemples non restrictifs ultérieurs.

Suivant une première caractéristique de l'invention, on réalise sur la pièce à revêtir une couche composite caractérisée en ce qu'elle est faite d'au moins trois couches unitaires successives à base d'un métal de transition M et d'un élément non métallique appelé non-métal m, ces couches unitaires étant constituées dans une proportion supérieure à 70 % par des combinaisons entre le métal de transition M et le non-métal m, tandis que par ailleurs les deux premières couches unitaires à partir de la surface extérieure sont faites respectivement de deux alliages $Mm_x$ du même métal de transition M et du même non-métal m, les compositions des deux dites couches unitaires ne diffèrent l'une de l'autre que par la valeur de l'indice x respectivement dans l'une et dans l'autre,

— la couche unitaire extérieure ayant une dureté supérieure à 1 000 Vickers ;

— la couche unitaire immédiatement en dessous de la couche extérieure ayant une dureté supérieure d'au moins 500 Vickers à celle de ladite couche unitaire extérieure.

Le non-métal peut être choisi dans le groupe carbone, azote, oxygène, silicium, bore. Suivant une deuxième caractéristique de l'invention, les compositions chimiques des couches unitaires successives sont très voisines les unes des autres, seule la dernière, c'est-à-dire celle immédiatement au contact du substrat, pouvant être de nature différente.

L'exemple suivant permettra de préciser ce qu'on entend par « compositions chimiques très voisines » :

Si l'on choisit par exemple de revêtir la pièce à l'aide d'une couche composite à base d'azote et de titane, les couches unitaires successives pourront être, en allant de l'extérieur vers l'intérieur :

— d'abord une couche unitaire de couleur jaune, correspondant à la composition stœchiométrique Ti N ;

— en dessous, une couche unitaire de couleur grise, correspondant à une composition non stœchiométrique Ti $N_x$, avec x compris entre 0,4 et 1 $(0,4 < x < 1)$ ;

— puis une autre couche de Ti N stœchiométrique ;

— etc.

Un autre exemple correspond au cas où la couche composite de revêtement serait à réaliser à base de carbone et de titane. Dans ce cas, les couches unitaires rencontrées pourraient avoir alternativement pour composition :

— l'alliage stœchiométrique Ti C ;

— l'alliage non stœchiométrique Ti $C_x$ ;

— à nouveau Ti C ; etc.

Autrement dit, le sens à attacher à l'expression « compositions chimiques très voisines » consiste en ce que seul l'indice x varie d'une couche unitaire à l'autre, mais non le choix des composants. Par exemple, l'invention ne concerne pas les successions telles que Ti N-Ti C-Ti N... à l'intérieur d'une même couche composite.

Suivant une autre caractéristique de l'invention, le module d'élasticité du composé qui constitue la couche unitaire extérieure est inférieur à 150 000 N/mm² et son épaisseur est inférieure à 5 micromètres.

Suivant une autre caractéristique de l'invention, la couche extérieure est constituée par au moins 90 % du composé métal/non-métal et celle qui la suit par au moins 70 % du composé de composition chimique voisine de celle du précédent.

Suivant une autre caractéristique de l'invention, la troisième couche que l'on rencontre à partir de la surface peut être la répétition de la couche extérieure et l'on peut alors mettre ainsi autant de couches unitaires superposées que l'on veut.

Suivant une autre caractéristique de l'invention, la couche immédiatement en dessous de la couche extérieure a une épaisseur inférieure à 5 micromètres.

Suivant une autre caractéristique de l'invention, la dernière couche immédiatement au contact du substrat a une dureté supérieure à 1 000 Vickers, et son épaisseur n'excède pas 20 micromètres.

L'invention concerne également un procédé de revêtement, tel que défini dans les revendications 17 à 24. Suivant un mode de réalisation privilégié de la couche composite selon l'invention, on fait appel à la pulvérisation cathodique, du type connu sous le nom de magnétron où l'on bombarde une cible du métal de transition considéré, par des ions d'un gaz neutre plasmagène tel le néon, l'argon, le xénon, ou le krypton en présence d'un gaz réactif susceptible de libérer le métalloïde qui se combinera avec le métal de transition pulvérisé, tel l'azote, l'ammoniac ou l'hydrazine.

Les strates successives de la couche composite selon l'invention sont obtenues en faisant varier successivement, dans les proportions requises, les trois paramètres principaux de mise en œuvre, c'est-à-dire :

— la pression partielle du gaz neutre plasmagène ;

— la pression partielle du gaz réactif ;

— la tension appliquée sur la cible, ou encore, ce qui est équivalent car découlant de la valeur de cette tension, la densité de puissance de la décharge cathodique.

Les dessins annexés et les exemples qui vont suivre permettront de mieux comprendre l'invention et ses avantages, étant entendu qu'ils ne sont donnés qu'à titre d'exemples non limitatifs.

La figure 1 est une vue en coupe montrant le minimum de trois couches superposées que comporte un revêtement selon l'invention dans le cas où l'on se propose de revêtir avec du nitrure de titane une pièce de support en acier.

Les figures 2 et 3 montrent deux variantes de réalisation d'une couche selon l'invention.

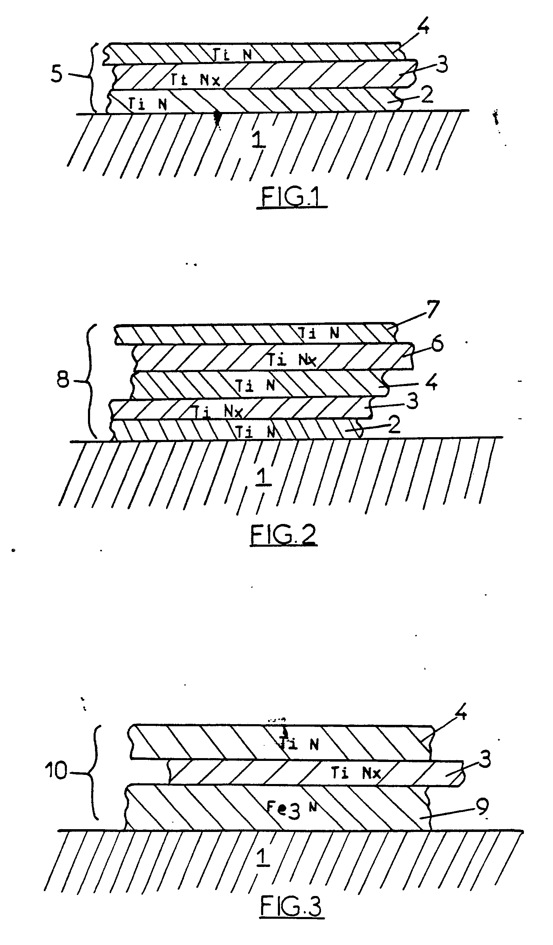

On a représenté sur la figure 1 une pièce en acier 1, qui pour le revêtement, constitue le support, ou substrat.

Selon l'invention, on commence par revêtir la pièce d'une couche mince 2 en nitrure de titane Ti N, dont l'épaisseur est inférieure à 5 micromètres.

On réalise ensuite par-dessus une seconde couche unitaire élémentaire en nitrure de titane Ti $N_x$ $(0,4) < x < 1)$ dont l'épaisseur est inférieure à 5 micromètres (couche 3).

Par-dessus cette seconde couche élémentaire 3, on dépose une troisième couche élémentaire 4 dont la composition chimique est Ti N.

Finalement, dans cet exemple, la pièce d'acier 1 est revêtue d'une couche composite 5 selon l'invention, formée des trois couches élémentaires 2, 3 et 4 illustrées en figure 1.

Dans la variante de la figure 2, on a représenté de la même façon une pièce d'acier 1, qui est revêtue non seulement des trois couches élémentaires 2, 3 et 4, mais également de couches unitaires supplémentaires, à savoir :
— une couche élémentaire 6 en Ti $N_x$, dont l'épaisseur est inférieure à 5 micromètres ;
— une couche élémentaire 7 en Ti N, dont l'épaisseur est inférieure à 5 micromètres.

Dans cet exemple de la figure 2, la pièce en acier 1 est revêtue d'une couche composite 8 formée de cinq couches élémentaires.

On pourrait bien entendu prévoir un nombre encore plus grand de couches élémentaires, dans lesquelles alterneraient Ti N et Ti $N_x$.

Dans l'exemple de la figure 3, on a représenté la pièce en acier 1 revêtue de trois couches unitaires, la première faite de nitrure de fer $Fe_3$ N, la seconde de Ti $N_x$ et la troisième, c'est-à-dire ici, la couche unitaire extérieure, faite de Ti N.

On constate que les revêtements donnés à titre d'exemples aux figures 1, 2 et 3, sont à la fois très résistants à l'usure, très résistants à la corrosion et très résistants à la fatigue. Par ailleurs, ces revêtements selon l'invention présentent les avantages suivants :
— les différents paramètres peuvent facilement être adaptés à une fabrication en série ;
— il est possible de réaliser une couche composite telle que 8, présentant une grande épaisseur totale : il suffit pour cela de multiplier le nombre des couches élémentaires extérieures telles que 3, 4, 6, 7 ... cela permet d'obtenir une couche composite finale de grande épaisseur sans pour cela accumuler les contraintes résiduelles.

En ce qui concerne les caractéristiques de la fabrication, elles peuvent correspondre aux données suivantes :
— application rapide des différentes couches élémentaires successives, par exemple par pulvérisation cathodique ;
— possibilité d'appliquer ce revêtement, non seulement sur des pièces en acier, mais sur les substrats les plus divers, qui peuvent être non seulement des métaux ou alliages métalliques, mais même de la céramique, du papier, de la matière plastique, etc.

On constate que la couche composite finale de nitrure de titane ainsi déposée est à la fois chimiquement très inerte et très dure.

Etant donné qu'à chaque nouvelle couche élémentaire telle que 2, 3, 4, 6, 7... on stoppe la croissance des germes initiaux, on repart sur d'autres germes pour déposer la couche suivante, ceci explique que dans les couches finales 5 ou 8, les contraintes résiduelles soient complètement libérées dans chaque couche élémentaire.

A titre d'illustration, on va maintenant décrire plus en détail quelques exemples possibles de réalisation selon l'invention.

Premier exemple

Il s'agit de faire un joint d'étanchéité du genre qui fait frotter l'une contre l'autre, deux surfaces planes annulaires.

Dans les joints classiques, une des deux pièces frottantes est souvent en graphite, la pièce antagoniste étant en acier.

Dans une version d'un tel joint fait selon l'invention, cette pièce antagoniste est revêtue de la façon suivante :

Dans une enceinte capable d'être mise sous vide, puis remplie de telle ambiance que l'on désire, sous la pression souhaitée, et équipée d'un système de pulvérisation cathodique du métal d'une cible, on dispose une cible en titane, et une ambiance d'azote.

Dans un premier temps, on procède à un dépôt dans les conditions définies par les paramètres suivants :
— pression d'argon (gaz support) : 0,66 Pa $(5 \times 10^{-3}$ torrs) ;
— pression d'azote : 0,04 Pa $(3 \times 10^{-4}$ torrs) ;
— cible en titane ;
— puissance de la décharge : P = 10 W/cm².

On obtient alors une couche de nitrure de titane Ti N de couleur jaune, que l'on laisse croître jusqu'à ce que son épaisseur atteigne quatre micromètres.

Dans un second temps, on garde les mêmes paramètres à l'exception de la pression d'azote que l'on ramène à 0,026 Pascals $(2 \times 10^{-4}$ torrs). On obtient alors une deuxième couche formée de nitrure Ti $N_{0,6}$, qu'on laisse croître elle aussi jusqu'à ce qu'elle atteigne une épaisseur de quatre micromètres.

On ramène ensuite la pression d'azote à la pression initiale de 0,04 Pascals $(3 \times 10^{-4}$ torrs), pour réaliser une nouvelle couche formée de nitrure de titane Ti N.

L'opération peut être répétée autant de fois que l'on veut, en formant ainsi des couches successives. Mais les trois premières couches unitaires suffisent pour être conformes à l'invention.

Le revêtement ainsi obtenu, conformément à l'invention présente une couche extérieure dont la dureté est de 2 000 Vickers, c'est-à-dire supérieure aux 1 000 Vickers requis ; son épaisseur est de quatre micromètres, c'est-à-dire inférieure aux cinq micromètres requis et son module de Young est de 95 000 N/mm², c'est-à-dire inférieur aux 150 000 N/mm² requis. En dessous, on constate l'existence d'une couche dont la dureté est de 2 800 Vickers (dont supérieure de plus de 500 Vickers à celle de la précédente). La troisième couche est formée de nitrure de titane Ti N, donc identique à la couche externe.

Or, ce revêtement, conforme à la présente invention, présente, par rapport à la solution classique, une résistance à la corrosion, selon le test classique du brouillard salin, cinq fois supérieure et une tenue au vieillissement mécanique par grippage et fatigue trois fois supérieure.

Deuxième exemple

Pour réaliser le joint d'étanchéité, on prend cette fois, une pièce en acier classique et on opère comme il est dit précédemment pour la revêtir des couches unitaires successives.

Toutefois, dans ce cas, la première couche est réalisée uniquement en ambiance d'azote, sans pulvérisation de titane. De la sorte, cette première couche formée est à base de nitrure de fer $Fe_3 N$. Les différentes couches unitaires ultérieures formées sont alors $Ti N$ et $Ti N_x$.

La couche composite finale formée se présente alors comme à la figure 3 précédemment décrite.

On obtient également ici une couche composite selon l'invention qui multiplie de plusieurs fois la résistance de la pièce au vieillissement par les quatre modes décrits précédemment.

La présente invention concerne également un perfectionnement aux exemples ci-dessus concernant une couche composite où le métal est le titane, tandis que le non-métal se combinant au titane est de l'azote.

Par une étude systématique de l'influence des différents paramètres de mise en œuvre précités, la demanderesse a découvert que si, pour gaz neutre plasmagène, on choisit l'argon en quantité telle que sa pression partielle soit comprise entre 0,33 et 0,8 Pascals ($2,5$-$6 \cdot 10^{-3}$ torrs) et si pour gaz réactif on choisit l'azote en quantité telle que sa pression partielle soit comprise entre 0,026 et 0,066 Pascals ($2$-$5 \cdot 10^{-4}$ torrs), si enfin la densité de puissance de la décharge cathodique est telle que sa valeur soit comprise entre 8 et 15 W/cm$^2$, on obtient alors à la fois une macrostructure et une microstructure originales et un accroissement surprenant de la résistance à l'abrasion et à la corrosion.

Plus précisément, le perfectionnement de cette couche à base de titane et d'azote s'obtient dans les conditions rigoureuses que voici, qui forment une partie de l'invention :

1. L'argon doit avoir une pureté supérieure à 99,8 %. Sa pression partielle doit être comprise entre 0,33 et 0,8 Pascals ($2,5$-$6 \cdot 10^{-3}$ torrs).

2. L'azote doit avoir une pureté supérieure à 98 %. Sa pression partielle doit être comprise entre 0,026 et 0,066 Pascals ($2$-$5 \cdot 10^{-4}$ torrs).

3. La cible cathodique est en titane qui doit avoir une pureté supérieure ou égale à 99 %.

4. La puissance de la décharge cathodique ramenée à l'unité de surface de la cible doit être comprise entre 8 et 15 W/cm$^2$.

5. La distance entre les pièces à revêtir et la cible cathodique doit être comprise entre 3 et 6 cm.

6. Les pièces à revêtir sont reliées électriquement à la masse.

A titre de variante possible du mode de mise en œuvre, les pièces à revêtir pourront être polarisées sous une tension négative, la valeur de cette tension ne devant pas excéder — 1 000 V.

On obtient alors le résultat surprenant que voici : parmi toutes les couches connues, la couche de mise en œuvre selon l'invention est celle qui résiste le mieux simultanément à la fois à l'abrasion et à la corrosion.

Certes, on a déjà relevé la tenue exceptionnelle à la corrosion de matériaux comme le tantale ou encore la résistance à l'abrasion de matériaux comme le carbure de chrome, mais aucun matériau ou revêtement connu ne possède de façon concomitante les quantités de la couche à base de titane et d'azote mises en œuvre selon les conditions de la présente invention.

On décrira maintenant, à titre non limitatif, quelques exemples de mise en œuvre selon l'invention :

Pour réaliser la couche à base de titane et d'azote, on opère de la façon suivante :

Dans une enceinte de pulvérisation cathodique magnétron où la cible est en titane (pureté : 99,5 %), on procède dans un premier temps à un dépôt avec les paramètres de mise en œuvre que voici :

— pression d'argon (pureté 99,99 %) : 0,43 Pascals ($3 \cdot 10^{-3}$ torrs) ;

— pression d'azote (pureté 99,9 %) : 0,066 Pascals ($5 \cdot 10^{-4}$ torrs) ;

— puissance de la décharge cathodique : 14 W/cm$^2$ ;

— distance entre pièce et cible cathodique : 5 m ;

— pièce à revêtir reliée électriquement à la terre.

On obtient alors une première couche que l'on laisse croître jusqu'à ce que son épaisseur atteigne 4 micromètres.

Dans un deuxième temps, on conserve les mêmes paramètres de mise en œuvre, à l'exception des pressions partielles des gaz qui sont ramenées respectivement à 0,3 Pascals ($2 \cdot 10^{-3}$ torrs) pour l'argon et 0,04 Pascals ($3 \cdot 10^{-4}$ torrs) pour l'azote. On obtient alors une deuxième couche que l'on laisse croître également jusqu'à une épaisseur de 4 micromètres.

Dans un troisième temps, on ramène la valeur de ces pressions partielles à la valeur initiale de la première opération. On obtient ainsi un revêtement dont la microdureté de la couche extérieure est de 2 600 Hv, celle de la couche sous-jacente de 3 300 Hv, celle enfin de la troisième couche de 2 600 Hv.

Soumise à un test classique de corrosion en brouillard salin, une pièce en acier XC (0,38 % de carbone) revêtue de ladite couche présente une résistance à la corrosion supérieure à 2 000 heures. Si l'on soumet par ailleurs une pièce en acier XC 38 revêtue de la couche selon l'invention à l'action d'un jet d'abrasif, sous une pression de 6 bars, la perte de poids relevée sur la pièce revêtue est de 2 mg.

A titre de comparaison, la perte de poids relevée sur une pièce revêtue de carbure de chrome, bien connu pour sa résistance à l'abrasion, est de 36 mg pour des conditions identiques d'essais.

A titre de comparaison, on décrit ci-après les résultats obtenus si l'on change la valeur d'un seul des paramètres de mise en œuvre, par exemple la pression partielle d'argon, les autres paramètres étant maintenus tels que dans l'exemple précédent :

C'est ainsi que, dans un premier temps, cette pression partielle d'argon est fixée à 1 Pascal $(7 \cdot 10^{-3}$ torrs), puis amenée à 1,3 Pascal $(10^{-2}$ torrs) dans une deuxième étape, et enfin à nouveau égale à 1 Pascal lors de la dernière étape du dépôt. De la sorte, pour chacune des trois opérations successives, la valeur de la pression partielle de gaz neutre d'argon se situe en dehors de la plage revendiquée selon l'invention.

De façon surprenante, la microdureté des différentes couches formées est inférieure à celle obtenue selon les conditions de l'invention et telle que décrite dans le premier exemple ci-dessus.

Ainsi, la microdureté de la couche externe est également à 1 500 Hv. Celle de la couche sous-jacente est égale à 2 200 Hv. Celle enfin de la troisième couche est égale à celle de la couche externe.

Mise en corrosion selon le test précité, une pièce en acier XC 38 revêtue de la couche composite ainsi réalisée présente une résistance à la corrosion qui ne dépasse pas 900 heures.

La perte de poids relevée après essai d'abrasion est de 6 mg.

## Revendications

1. Couche composite pour revêtir un substrat et pour résister à la fois au grippage, à l'abrasion, à la fatigue par contraintes alternées et à la corrosion, caractérisée en ce qu'elle est faite d'au moins trois couches unitaires successives à base d'un métal de transition (M) et d'un élément non métallique appelé non-métal (m), ces couches unitaires étant constituées dans une proportion supérieure à 70 % par des combinaisons entre le métal de transition (M) et le non-métal (m), tandis que par ailleurs les deux premières couches unitaires à partir de la surface extérieure sont faites respectivement de deux alliages $Mm_x$ du même métal de transition (M) et du même non-métal (m), les compositions des deux dites couches unitaires ne différant l'une de l'autre que par la valeur de l'indice x respectivement dans l'une et dans l'autre :

— la couche unitaire extérieure ayant une dureté supérieure à 1 000 Vickers

— la couche unitaire immédiatement en dessous de la couche extérieure ayant une dureté supérieure d'au moins 500 Vickers à celle de ladite couche unitaire extérieure.

2. Couche composite suivant la revendication 1, caractérisée en ce que la couche unitaire extérieure a une épaisseur inférieure à cinq micromètres, tandis que le module d'élasticité du composé qui la constitue est inférieur à 150 000 N/mm².

3. Couche composite suivant les revendications 1 et 2 caractérisée en ce que la couche unitaire immédiatement en dessous de la couche unitaire extérieure a une épaisseur inférieure à cinq micromètres.

4. Couche composite suivant la revendication 1, caractérisée en ce que la dernière couche unitaire directement au contact du substrat a une dureté supérieure à 1 000 Vickers et une épaisseur inférieure à vingt micromètres.

5. Couche composite suivant la revendication 1, caractérisée en ce que le non-métal (m) entrant dans la composition des couches unitaires est choisi parmi le carbone, l'azote, l'oxygène, le silicium, le bore.

6. Couche composite suivant la revendication 1, caractérisée en ce que l'indice x des alliages $Mm_x$ constituant les couches unitaires est compris entre 0,4 et 1.

7. Couche composite suivant la revendication 1, caractérisée en ce que la couche unitaire extérieure est composée d'au moins 90 % du composé métal/non-métal.

8. Couche composite suivant la revendication 1, caractérisée en ce que la couche unitaire sous-jacente à la couche extérieure comporte une proportion d'au moins 70 % du composé métal/non-métal.

9. Couche composite suivant la revendication 1, caractérisée en ce qu'elle comporte plus de trois couches unitaires successives, les couches unitaires supplémentaires étant des répétitions des deux premières.

10. Couche composite suivant la revendication 1, caractérisée en ce que la dernière couche immédiatement au contact du substrat est la répétition de la couche unitaire extérieure.

11. Couche composite suivant la revendication 1, caractérisée en ce que le métal (M) entrant dans la composition des couches unitaires est choisi parmi le titane, le tantale, l'hafnium, le chrome, le molybdène, le tungstène.

12. Couche composite suivant la revendication 1, caractérisée en ce que les couches unitaires successives sont formées à base de titane et d'azote.

13. Couche composite suivant la revendication 1, caractérisée en ce que les couches unitaires successives sont formées à base de titane et de carbone.

14. Couche composite suivant la revendication 1, caractérisée en ce que les couches unitaires successives sont formées à base de tantale et d'azote.

15. Couche composite suivant la revendication 1, caractérisée en ce que la dernière couche unitaire immédiatement au contact du substrat est constituée par une combinaison métal/non-métal dans laquelle le métal est le fer.

16. Couche composite suivant les revendications 1 et 15, caractérisée en ce que la dernière couche unitaire immédiatement au contact du substrat est à base de nitrure de fer.

17. Procédé pour revêtir un substrat à l'aide d'une couche composite déposée en phase gazeuse suivant l'une quelconque des revendications précédentes, caractérisé en ce qu'avant de déposer chaque couche unitaire, on stoppe dans la couche unitaire précédente, la croissance des germes cristallins initiaux avant de repartir sur d'autres germes cristallins pour la couche unitaire suivante, les conditions du dépôt étant modifiées de façon discontinue pour passer d'une couche unitaire à l'autre.

18. Procédé selon la revendication 17, dans lequel la couche composite est réalisée à base de titane et d'azote, caractérisé en ce que pour sa réalisation, on fait appel à la pulvérisation cathodique magnétron en réunissant simultanément les conditions rigoureuses suivantes :
— la pression partielle de gaz neutre plasmagène est comprise entre 0,33 et 0,8 Pa (2,5 et $6 \cdot 10^{-3}$ torrs) ;
— la pression partielle de gaz réactif choisi pour sa faculté de fournir de l'azote à la réaction de nitruration du titane est comprise entre 0,026 et 0,066 Pa (2 et $5 \cdot 10^{-4}$ torrs) ;
— la densité de puissance de la décharge cathodique est comprise entre 8 et 15 W/cm$^2$.

19. Procédé suivant la revendication 18, caractérisé en ce que la cible de pulvérisation utilisée est en titane de pureté supérieure ou égale à 99 %.

20. Procédé suivant la revendication 18, caractérisé en ce que le gaz neutre plasmagène est choisi parmi le néon, l'argon, le krypton, le xénon.

21. Procédé suivant la revendication 18, caractérisé en ce que le gaz neutre plasmagène est l'argon.

22. Procédé suivant la revendication 18, caractérisé en ce que le gaz réactif choisi pour sa faculté de fournir de l'azote à la réaction de nitruration du titane est choisi parmi l'azote, l'ammoniac, l'hydrazine.

23. Procédé suivant la revendication 18, caractérisé en ce que, pour sa mise en œuvre, la distance entre la pièce à revêtir et la cible cathodique est comprise entre 3 et 6 cm.

24. Procédé suivant la revendication 18, caractérisé en ce que, pour sa mise en œuvre, la pièce à revêtir de la couche composite est polarisée sous une tension négative n'excédant pas — 1 000 volts.

25. Pièce revêtue d'une couche composite suivant l'une quelconque des revendications 1 à 16.

## Claims

1. A composite layer for covering a base substance in order to resist at the same time seizing, abrasion, fatigue caused by alternating stressess, and corrosion, characterised in that it is made up of at least three successive unitary layers with a base of a transitional metal (M) and a non-metallic component referred to as non-metal (m), these unitary layers being constituted in a proportion greater than 70 % by combinations between the transitional metal (M) and the non-metal (m), whilst in addition the first two unitary layers from the external surface are composed respectively of two compounds $Mm_x$ of the same transitional metal (M) and of the same non-metal (m), the compositions of the two said unitary layers differing only by the value of the index x in each :
— the external unitary layer having a hardness greater than 1 000 Vickers
— the unitary layer immediately below the external layer having a hardness greater by at least 500 Vickers than that of the said external unitary layer.

2. A composite layer according to Claim 1, characterised in that the external unitary layer has a thickness less than 5 micrometers, whilst the modules of elasticity of the compound which constitutes it is less than 150 000 N/mm$^2$.

3. A composite layer according to Claims 1 and 2, characterised in that the unitary layer immediately below the external unitary layer has a thickness less than 5 micrometers.

4. A composite layer according to Claim 1, characterised in that the last unitary layer directly in contact with the base substance has a hardness greater than 1 000 Vickers and a thickness less than 20 micrometers.

5. A composite layer according to Claim 1, characterised in that the non-metal (m) forming part of the composition of the unitary layers is chosen from carbon, nitrogen, oxygen, silica and boron.

6. A composite layer according to Claim 1, characterised in that the index x of the compounds $Mm_x$ constituting the unitary layers lies between 0.4 and 1.

7. A composite layer according to Claim 1, characterised in that the external unitary layer is composed of at least 90 % of the metal/non-metal compound.

8. A composite layer according to Claim 1, characterised in that the unitary layer lying below the external layer has a proportion of at least 70 % of the metal/non-metal compound.

9. A composite layer according to Claim 1, characterised in that it includes more than 3 successive unitary layers, the additional unitary layers being repetitions of the first two.

10. A composite layer according to Claim 1, characterised in that the last layer immediately in contact with the base substance is a repetition of the external unitary layer.

11. A composite layer according to Claim 1, characterised in that the metal (M) forming part of the composition of the unitary layers, is chosen from titanium, tantalum, hafnium, chromium, molybdenum and tungsten.

12. A composite layer according to Claim 1, characterised in that the successive unitary layers are formed from a base of titanium and nitrogen.

13. A composite layer according to Claim 1, characterised in that the successive unitary layers are formed from a base of titanium and carbon.

14. A composite layer according to Claim 1, characterised in that the successive unitary layers are formed from a base of tantalum and nitrogen.

15. A composite layer according to Claim 1, characterised in that the last unitary layer immediately in contact with the base substance is constituted by a metal/non-metal compound in which the metal is iron.

16. A composite layer according to Claims 1 and 15, characterised in that the last unitary layer immediately in contact with the bast substance is from a base of iron nitride.

17. A process for coating a base substance with a composite layer deposited in a gaseous phase according to any one of the preceding claims, characterised in that before depositing each unitary layer, the growth of the initial crystal nuclei is stopped in the preceding unitary layer before beginning again with other crystalline nuclei for the following unitary layer, the conditions for the deposition being modified in a discontinuous way in order to pass from one unitary layer to another.

18. A process according to Claim 17, in which the composite layer is made from a base of titanium and nitrogen, characterised in that in order to carry it out use is made of cathodic magnetron spraying while simultaneously bringing about the following strict conditions :
— the partial pressure of plasma-producing neutral gas lies between 0.33 and 0.8 Pa ;
— the partial pressure of re-active gas chosen for its ability to supply nitrogen for the re-action of nitridation of titanium lies between 0.26 and 0.66 Pa ;
— the power density of the cathodic discharge lies between 8 and 15 W/cm$^2$.

19. A process according to Claim 18, characterised in that the spraying target used for its manufacture is made from titanium of a purity greater than or equal to 99 %.

20. A process according to Claim 18, characterised in that the plasma-producing neutral gas is chosen from neon, argon, krypton, xenon.

21. A process according to Claim 18, characterised in that the plasma-producing neutral gas is argon.

22. A process according to Claim 18, characterised in that the re-active gas chosen for its ability to furnish nitrogen for the reaction of nitridation of titanium is chosen from nitrogen, ammonia and hydrazine.

23. A process according to Claim 18, characterised in that, in order to carry it out, the distance between the part to be coated and the cathodic target lies between 3 and 6 cm.

24. A process according to Claim 18, characterised in that, in order to carry it out, the part to be coated with the composite layer is polarised at a negative voltage not exceeding — 1 000 volts.

25. A part coated with a composite layer according to any one of Claims 1 to 16.

**Patentansprüche**

1. Zusammengesetzte Schicht zum Verkleiden einer Unterlage und zur Ausbildung der Widerstandsfähigkeit gegen Abnutzung, Abrieb, Ermüdung durch Wechseleinwirkung und Korrosion, gekennzeichnet durch mindestens drei aufeinander folgende, in sich einheitliche Schichten, die auf der Grundlage eines Übergangsmetalls (M) und eines nichtmetallischen Elementes, genannt Nichtmetall (m), zusammengesetzt sind, wobei die einheitlichen Schichten aus über 70 % der Verbindung zwischen dem Übergangsmetall (M) und dem Nichtmetall (m) bestehen, die beiden ersten einheitlichen Schichten mit ihrer Außenfläche aus zwei Legierungen (Mm$_x$) des gleichen Übergangsmetalls (M) und des gleichen Nichtmetalls (m) bestehen, wobei die Zusammensetzung der genannten einheitlichen Schichten voneinander nicht unterschiedlich ist mit Ausnahme des Index (x) in der

einen oder anderen Schicht, und daß die äußere einheitliche Schicht eine Oberflächenhärte über 1 000 Vicker und

die Zwischenschicht direkt unter der äußeren Schicht eine Oberflächenhärte von mindestens 500 Vicker an der der äußeren Schicht zugewandten Seite hat.

2. Schicht nach Anspruch 1, dadurch gekennzeichnet, daß die einheitliche äußere Schicht eine Dicke unter 5 Micrometer hat und das Elastizitätsmodul unter 150 000 N/mm$^2$ liegt.

3. Schicht nach den Ansprüchen 1 und 2, dadurch gekennzeichnet, daß die mittlere Schicht, die direkt unter der äußeren Schicht liegt, eine Dicke unter 5 Micrometer hat.

4. Schicht nach Anspruch 1, dadurch gekennzeichnet, daß die unterste Schicht, die direkte Berührung zu der Unterlage hat, eine Oberflächenhärte über 1 000 Vicker und eine Dicke unter 20 Micrometer aufweist.

5. Schicht nach Anspruch 1, dadurch gekennzeichnet, daß das Nichtmetall (m) innerhalb der Zusammensetzung der Schicht wahlweise aus Kohlenstoff, Stickstoff, Sauerstoff, Silizium oder Bor besteht.

6. Schicht nach Anspruch 1, dadurch gekennzeichnet, daß der Index (x) der Legierung (Mm$_x$) zwischen 0,4 und 1 liegt.

7. Schicht nach Anspruch 1, dadurch gekennzeichnet, daß die äußere einheitliche Schicht aus mindestens 90 % der Metall/Nichtmetallzusammensetzung besteht.

8. Schicht nach Anspruch 1, dadurch gekennzeichnet, daß die Schicht, die direkt unter der äußeren Schicht liegt, aus mindestens 70 % der Metall/Nichtmetallzusammensetzung besteht.

9. Schicht nach Anspruch 1, gekennzeichnet durch mehr als drei aufeinander folgende einheitliche Schichten, wobei die zusätzlichen Schichten eine Wiederholung der zwei ersten Schichten sind.

10. Schicht nach Anspruch 1, dadurch gekennzeichnet, daß die letzte Schicht direkte Berührung mit der Unterlage hat und eine Wiederholung der äußeren Schicht ist.

11. Schicht nach Anspruch 1, dadurch gekennzeichnet, daß das Metall (M) in der Zusammensetzung der einheitlichen Schichten wahlweise aus Titan, Tantal, Hafnium, Molybden oder Wolfram besteht.

12. Schicht nach Anspruch 1, dadurch gekennzeichnet, daß die aufeinander folgenden einheitlichen Schichten auf der Basis von Titan und Stickstoff gebildet sind.

13. Schicht nach Anspruch 1, dadurch gekennzeichnet, daß die aufeinander folgenden Schichten auf der Basis von Titan und Kohlenstoff gebildet sind.

14. Schicht nach Anspruch 1, dadurch gekennzeichnet, daß die aufeinander folgenden Schichten auf der Basis von Tantal und Stickstoff gebildet sind.

15. Schicht nach Anspruch 1, dadurch gekennzeichnet, daß die Schicht mit direkter Berührung der Unterlage aus einer Kombination von Metall/Nichtmetall besteht, wobei das Metall Eisen ist.

16. Schicht nach Anspruch 1, dadurch gekennzeichnet, daß die direkt auf der Unterlage aufliegende Schicht auf der Basis einer Stickstoffeisenverbindung gebildet ist.

17. Verfahren zum Verkleiden einer Unterlage mit Hilfe einer zusammengesetzten Schicht, die sich in einer gasförmigen Phase abgelagert hat, nach einem der Ansprüche 1 bis 16, dadurch gekennzeichnet, daß vor der Ablagerung jeder einheitlichen Schicht das Wachsen der Initialkristallkeime vor dem Verteilen auf andere Kristallkeime der folgenden einheitlichen Schicht angehalten wird, wobei die Bedingungen für die Ablagerung so unterbrochen werden, daß jeweils eine einheitliche Schicht nach der anderen ausgebildet wird.

18. Verfahren nach Anspruch 17, wobei die zusammengesetzte Schicht auf der Basis von Titan und Stickstoff gebildet wird, dadurch gekennzeichnet, daß ein pulverisierendes, kathodisches Magnetron zur gleichzeitigen Vereinigung unter folgenden genauen Bedingungen verwendet wird :

Der partielle Druck des neutralen Plasma-Gases liegt zwischen 0,33 und 0,8 Pa ;

Der partielle Druck des reaktiven Gases beträgt wahlweise je nach den Eigenschaften des Stickstoffs zur Nitridierung mit Titan zwischen 0,26 und 0,66 Pa ;

Die Dichte der Leistung zur Entladung der Kathode liegt zwischen 8 und 15 W/cm$^2$.

19. Verfahren nach Anspruch 18, dadurch gekennzeichnet, daß das Ziel der Pulverisation, die zur Fabrikation gebraucht wird, Titan mit einer Reinheit über oder gleich 99 % ist.

20. Verfahren nach Anspruch 18, dadurch gekennzeichnet, daß das neutrale Plasma-Gas wahlweise Neon, Argon, Krypton oder Xenon ist.

21. Verfahren nach Anspruch 18, dadurch gekennzeichnet, daß das neutrale Plasma-Gas Argon ist.

22. Verfahren nach Anspruch 18, dadurch gekennzeichnet, daß das reaktive Gas je nach Eigenschaft des Stickstoffs zur Nitridierung des Titans wahlweise Stickstoff, Ammoniak oder Hydrazin ist.

23. Verfahren nach Anspruch 18, dadurch gekennzeichnet, daß zum Verarbeiten die Entfernung zwischen dem Stück, das verkleidet werden soll, und der Kathode 3 bis 6 cm beträgt.

24. Verfahren nach Anspruch 18, dadurch gekennzeichnet, daß zur Verarbeitung das Stück, das mit der zusammengesetzten Schicht verkleidet werden soll, unter einer negativen Spannung polarisiert wird, die nicht — 1 000 Volt überschreitet.

25. Mit einer zusammengesetzten Schicht verkleidetes Stück nach einem der Ansprüche 1 bis 16.

FIG.1

FIG.2

FIG.3

1